Europäisches Patentamt

European Patent Office

Office européen des brevets

(19)

(11) **EP 0 939 324 A1**

(12) **DEMANDE DE BREVET EUROPEEN**

(43) Date de publication:
**01.09.1999 Bulletin 1999/35**

(51) Int Cl.$^6$: **G02B 6/124**, H01S 3/085

(21) Numéro de dépôt: **99400420.8**

(22) Date de dépôt: **22.02.1999**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **26.02.1998 FR 9802321**

(71) Demandeur: **ALCATEL**
**75008 Paris (FR)**

(72) Inventeurs:
• **Bissessur, Hans**
**75014 Paris (FR)**
• **Graver, Catherine**
**91290 La Norville (FR)**

(74) Mandataire: **Fournier, Michel Robert Marie et al**
**COMPAGNIE FINANCIERE ALCATEL**
**Dépt. Propriété Industrielle,**
**30, avenue Kléber**
**75116 Paris (FR)**

(54) **Réflécteur optique en semi-conducteur et procédé de fabrication**

(57) L'invention concerne un réflecteur optique en semiconducteur destiné notamment à être disposé en regard d'une cavité laser intégrée pour réalimenter cette dernière et permettre son oscillation en continu. Le réflecteur comprend plusieurs sections ($S_i$, $S_{i+1}$) de réflecteur de Bragg en cascade. Il est plus particulièrement caractérisé en ce que lesdites sections sont de même longueur L et ont un même coefficient de couplage ($\kappa$), et en ce que la longueur L de chacune desdites sections est donnée par la relation suivante :

$$L = \lambda^2 / [\, (n_{i+1} + n_i) \times 1{,}7(n_{i+1}\,\Lambda_{i+1} - n_i\,\Lambda_i)]$$

où $\lambda$ est la valeur moyenne des longueurs d'ondes de Bragg réfléchies par le réflecteur,

$n_{i+1}$ et $n_i$ sont les indices de réfraction effectifs respectivement desdites sections adjacentes ($S_{i+1}$, $S_i$), et

$\Lambda_{i+1}$ et $\Lambda_i$ sont les périodes respectivement desdites sections adjacentes ($S_{i+1}$, $S_i$).

Le réflecteur selon l'invention présente une large fenêtre spectrale, indépendante de la valeur du coefficient de couplage.

FIG_4A

**Description**

La présente invention se rapporte à un réflecteur optique en semi-conducteur et à son procédé de fabrication. Elle se rapporte plus particulièrement à un réflecteur optique comprenant plusieurs sections de réflecteurs de Bragg en cascade. Les réflecteurs de Bragg permettent de réfléchir une partie de la lumière qu'ils reçoivent. Ils sont couramment utilisés dans le domaine des transmissions optiques. Ils peuvent ainsi être disposés en regard d'une cavité laser intégrée pour réalimenter cette dernière et permettre son oscillation en continu. Dans ce cas, ils remplacent les miroirs à faces clivées des lasers semiconducteurs non intégrés.

Un réflecteur de Bragg est plus particulièrement défini par un réseau périodique constitué de deux matériaux possédant des indices de réfraction différents. Le taux de réflexion d'un tel dispositif dépend à la fois de la différence d'indice entre les deux matériaux de constitution et de la géométrie du réseau. Il est en effet proportionnel au produit K.L, L étant la longueur du réseau, et K étant un coefficient de couplage lié d'une part à la différence d'indice entre les deux matériaux et d'autre part à l'épaisseur du réseau.

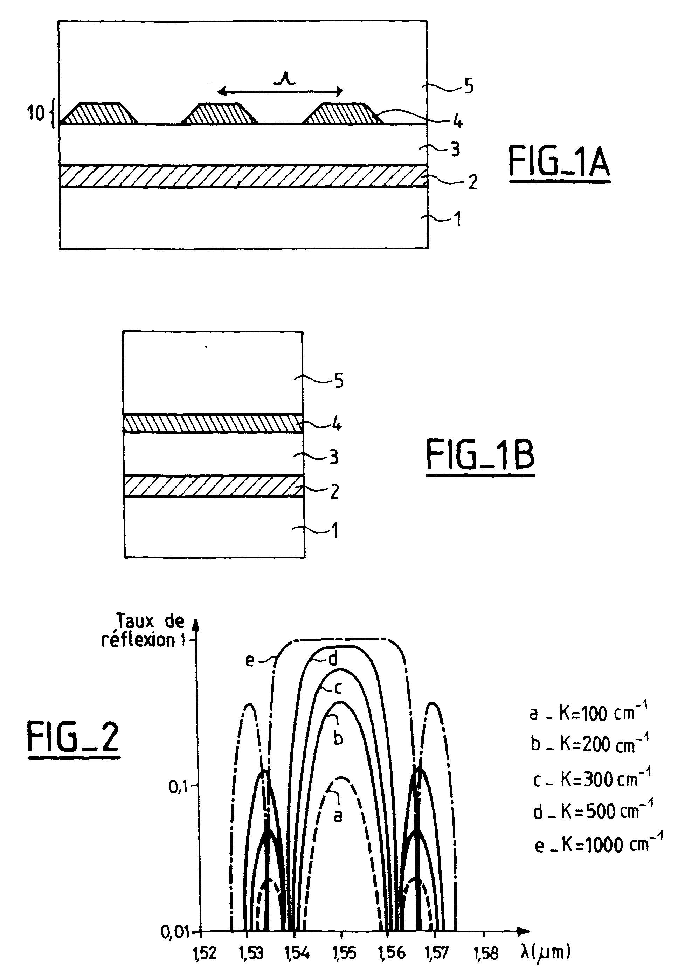

Un réflecteur classique est représenté en coupe transversale suivant le sens de la longueur sur la figure IA et en coupe transversale suivant le sens de la largeur sur la figure 1B. Ce réflecteur est réalisé sur des couches 2,3 empilées par épitaxie sur un substrat 1. Le substrat 1 est en général réalisé en phosphure d'indium (InP) dopé en porteurs de type n. Les couches empilées remplissent différentes fonctions optiques. Dans l'exemple représenté sur les figures 1A et 1B, une couche active 2, encore dénommée guide d'onde, est déposée sur le substrat 1. Cette couche active 2 est enterrée dans une couche 3 dite couche de gaine inférieure et réalisée dans un matériau de type III-V tel que de l'InP.

Le réseau de Bragg est référencé 10 sur la figure 1A. Il comporte un matériau 4 à base d'InP, comme par exemple un matériau quaternaire de type GaInAsP, représenté en hachuré sur les figures 1A et 1B, et un matériau 5 d'InP constitutif d'une couche de gaine supérieure.

Ce réseau est réalisé en faisant croître par épitaxie, sur la couche de gaine inférieure, une couche 4 du matériau quaternaire, en gravant cette couche 4 selon une configuration crénelée présentant une période A, puis en rebouchant les créneaux formés par une couche de gaine supérieure d'InP 5 dopé en porteurs. Le matériau quaternaire de GaInAsP 4 et l'InP 5 possédant des indices de réfraction différents, qui sont respectivement égaux à 3,3 et à 3, le réseau holographique 10 ainsi formé permet de réfléchir partiellement l'onde lumineuse qu'il reçoit.

Cependant, comme l'indique la figure 2, pour que la fenêtre spectrale de ce type de réseau soit suffisamment large, c'est à dire pour que ce réseau puisse être utilisé pour un grand nombre de longueurs d'onde, son coefficient de couplage K doit être très élevé. Ainsi, d'après les courbes de la figure 2 qui correspondent à un réseau classique de 35μm de long, pour obtenir une largeur spectrale de l'ordre de 20 nm, le coefficient de couplage K doit être de l'ordre de 500 cm$^{-1}$; et pour obtenir une largeur spectrale de l'ordre de 30nm, le coefficient de couplage K doit être de l'ordre de 1000 cm$^{-1}$. Or un fort coefficient de couplage implique la réalisation d'un réseau présentant un fort saut d'indice et/ou une épaisseur importante.

Pour réaliser un tel réseau à coefficient de couplage élevé, une première solution consiste à augmenter l'épaisseur du réseau de telle manière que l'onde lumineuse perçoive un contraste le plus important possible. Ce contraste est lié à la fois à la nature du matériau et à l'épaisseur du réseau, c'est à dire à l'épaisseur de la couche du matériau quaternaire. Cependant, cette solution ne permet pas, en pratique, de réaliser un réflecteur présentant les performances désirées. En effet, si les créneaux réalisés dans le matériau quaternaire sont trop profonds, l'étape de rebouchage devient difficile à exécuter sans dégrader la qualité cristalline du matériau de rebouchage c'est à dire de la couche de gaine supérieure. Or, lorsque la qualité cristalline de cette couche est affectée, des pertes de propagation lumineuse apparaissent si bien que les performances du dispositif sont amoindries et le coefficient de Bragg κ n'augmente pas suffisamment pour obtenir une large fenêtre spectrale.

Une autre solution a été envisagée pour augmenter le saut d'indice. Cette solution consiste à graver un réseau holographique, obtenu de manière classique entre un matériau quaternaire (ou ternaire) 4 et une couche de gaine en InP 5, pour éliminer de manière sélective le matériau quaternaire (ou ternaire) et réaliser une autre structure réseau à fort saut d'indice entre l'air et le semi-conducteur en InP. Dans ce cas, la valeur du saut d'indice est forte et de l'ordre de 2. Cependant, même si il présente une large fenêtre spectrale, ce type de réseau présente de nombreuses pertes de couplage à l'interface, lorsqu'on le couple au guide d'onde d'un autre dispositif, tel qu'un dispositif laser par exemple.

Il est par conséquent difficile d'augmenter le coefficient de couplage κ d'un réseau holographique de Bragg sans dégrader ses performances.

Un but de la présente invention consiste donc à trouver une solution pour réaliser un réflecteur optique en semi-conducteur présentant une large bande spectrale et ceci quelle que soit la valeur du coefficient de couplage K, afin de s'affranchir des problèmes que posent la réalisation d'un réseau à coefficient de couplage élevé.

Une solution pour réaliser un tel réflecteur ayant été étudiée consiste à fabriquer un réseau à période Λ continûment variable. Cette solution semble intéressante, sur le plan théorique, car un tel réseau présente une large fenêtre spectrale indépendamment du coefficient de couplage. Cependant, dans la pratique, la fabrication d'un tel réseau est fastidieuse et longue à mettre en oeuvre. En effet, ce type de réseau à période variable ne peut pas être fabriqué selon un procédé classique par interférences holographiques. Un autre procédé utilisé pour fabriquer ce type de réseau nécessite autant d'étapes de gravures qu'il y a de valeurs de périodes différentes. Par conséquent, la difficulté et la durée de mise en oeuvre sont considérablement accrues et la rentabilité du procédé est très amoindrie.

La présente invention permet de palier les inconvénients précités puisqu'elle propose un réflecteur optique en semi-conducteur comprenant plusieurs sections de réflecteur de Bragg en cascade et présentant une large fenêtre spectrale indépendante de la valeur du coefficient de couplage.

Ce réflecteur optique est plus particulièrement caractérisé en ce que lesdites sections sont de même longueur L et ont un même coefficient de couplage, et en ce que la longueur L de chacune des sections adjacentes $S_{i+1}$ et $S_i$ est donnée par la relation suivante:

$$L = \lambda^2 / [ (n_{i+1} + n_i) \times 1{,}7(n_{i+1} \times \Lambda_{i+1} - n_i \times \Lambda_i) ]$$

où

- $\lambda$ est la valeur moyenne des longueurs d'onde de Bragg réfléchies par le réflecteur,
- $n_{i+1}$ et $n_i$ sont les indices de réfraction effectifs respectivement desdites sections adjacentes $S_{i+1}$ et $S_i$, et
- $\Lambda_{i+1}$ et $\Lambda_i$ sont les périodes respectivement desdites sections adjacentes $S_{i+1}$ et $S_i$.

D'après la formule de la longueur L des sections du réflecteur, il est donc possible de faire varier la période effective d'une section à l'autre, c'est à dire: soit l'indice de réfraction effectif, soit la période de réseau.

L'indice de réfraction effectif est défini comme étant l'indice moyen des milieux que rencontre une onde lumineuse dans une section. La période effective est définie comme étant le produit de la période réellement inscrite par l'indice de réfraction effectif que rencontre une onde lumineuse dans une section.

Le procédé de fabrication du réflecteur selon l'invention est différent selon que l'on fait varier l'indice de réfraction effectif ou la période.

Ainsi, dans le cas où l'on fait varier l'indice de réfraction effectif, le procédé de fabrication consiste dans un premier temps à réaliser une structure empilée classique comprenant un réseau holographique de Bragg possédant une période $\Lambda$ donnée et un coefficient de couplage $\kappa$ donné. Ce procédé est caractérisé en ce qu'il consiste, dans un deuxième temps, à graver latéralement la structure empilée de manière à former des sections de réseau holographique en cascade présentant chacune une largeur différente.

Ce procédé est très simple et rapide à mettre en oeuvre car le réseau holographique de la structure empilée est réalisé de manière classique, sans chercher à augmenter le saut d'indice ou la profondeur, et la formation des sections en cascade se fait en une seule étape de gravure.

Dans le cas où l'on fait varier la période $\Lambda$, le procédé de fabrication consiste dans un premier temps à réaliser une structure empilée comprenant une couche supérieure en matériau ternaire ou en matériau quaternaire destinée à être gravée pour former un réseau holographique. Ce procédé est caractérisé en ce qu'il consiste ensuite à:

- graver la couche supérieure sur une section $S_i$ de longueur L, selon une configuration crénelée avec une période donnée $\Lambda_i$,
- graver successivement la couche supérieure sur une section $S_{i+1}$ adjacente à la précédente $S_i$, de même longueur L, selon une configuration crénelée avec une autre période $\Lambda_{i+1}$,
- puis, après avoir effectuer successivement la gravure des créneaux de chaque section, procéder indifféremment à la gravure de toutes les sections adjacentes de manière à ce qu'elles présentent une même largeur W et au dépôt d'une couche de gaine, en matériau III-V, afin de reboucher les créneaux et de créer plusieurs sections en cascade de réseau holographique présentant chacun une période différente.

Ce procédé holographique est un peu plus long que le précédent. Il reste cependant simple à mettre en oeuvre et il est facilement contrôlable contrairement au procédé de fabrication d'un réseau à période continûment variable.

D'autres particularités et avantages de l'invention apparaîtront à la lecture de la description suivante donnée à titre d'exemple illustratif mais non limitatif et faite en regard des figures annexées qui représentent :

- les figures 1A et 1B, déjà décrites, respectivement une vue en coupe transversale suivant le sens de la longueur et une vue en coupe transversale suivant le sens de la largeur d'un réflecteur de Bragg classique,
- la figure 2, déjà décrite, des courbes illustrant l'évolution de la largeur de la fenêtre spectrale d'un réflecteur de Bragg classique en fonction de son coefficient de couplage $\kappa$,

- la figure 3, des courbes illustrant le profil de la fenêtre spectrale d'un réflecteur selon l'invention en fonction de la longueur L des sections de réseau de Bragg composant le réflecteur,
- la figure 4A, un schéma d'une vue de dessus d'un premier mode de réalisation d'un réflecteur selon l'invention,
- la figure 4B, une courbe illustrant la valeur de l'indice de réfraction effectif d'une section de réseau de Bragg en fonction de sa largeur W,
- la figure 5, un schéma d'une vue de dessus d'un deuxième mode de réalisation d'un réflecteur selon l'invention,
- la figure 6, des courbes illustrant le profil de la fenêtre spectrale d'un réflecteur selon l'invention en fonction de son coefficient de couplage $\kappa$,
- la figure 7, des courbes illustrant le profil de la fenêtre spectrale d'un réflecteur selon l'invention en fonction du nombre de sections adjacentes.

Un réflecteur optique en semi-conducteur selon la présente invention comporte avantageusement plusieurs sections de réseau holographique de Bragg en cascade. Cette succession de sections de réseau de Bragg permet notamment d'élargir la fenêtre spectrale du réflecteur tout en conservant des coefficients de couplage raisonnables, c'est à dire inférieurs à 500 cm$^{-1}$.

Cependant, dans ce type de réflecteur, la longueur des sections en cascade est très importante et doit être contrôlée car elle influe grandement sur le profil de la fenêtre spectrale.

Les sections de réflecteur de Bragg du réflecteur selon l'invention doivent toutes avoir la même longueur L pour obtenir une fenêtre spectrale symétrique. En effet, dans le cas d'un réflecteur comportant deux sections en cascade de longueurs différentes, la fenêtre spectrale présente une dissymétrie car il se crée un pic de réflexion plus important centré sur la longueur d'onde moyenne réfléchie par la section la plus longue.

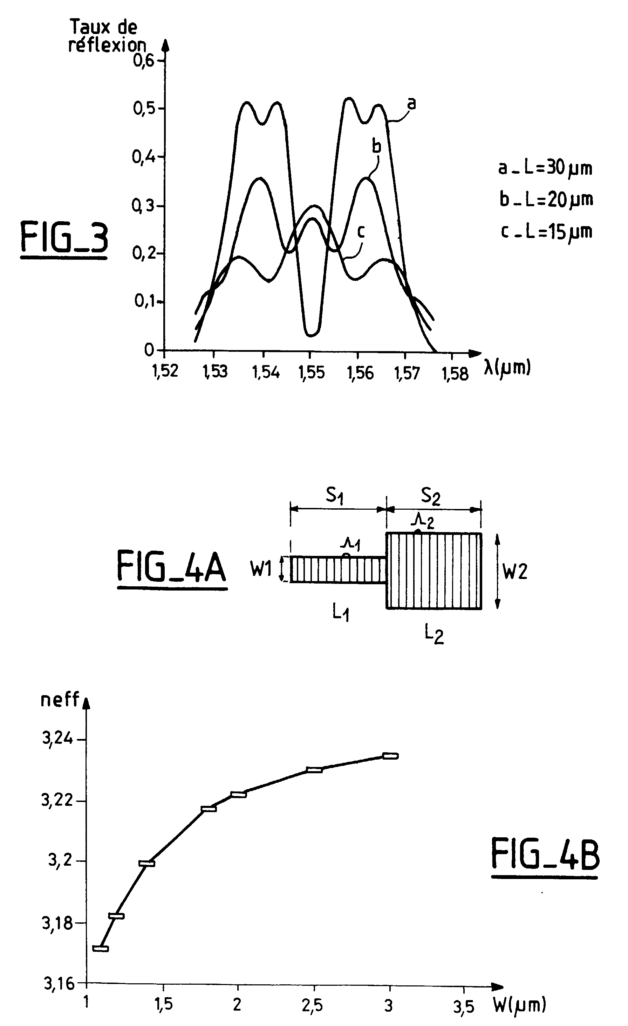

D'autre part, pour que la fenêtre spectrale du réflecteur soit la plus large possible, il faut nécessairement qu'elle présente un profil le plus plat possible. Sur la figure 3, les courbes a, b et c représentent le profil de la fenêtre spectrale d'un réflecteur selon l'invention, comportant deux sections de réseau de Bragg de même longueur L égale respectivement à 30 μm, 20μm, et 15μm. La fenêtre spectrale possède deux pics de réflexion latéraux et un pic central. Pour avoir un profil le plus plat possible, il faut donc que les pics central et latéraux présentent tous sensiblement le même taux de réflexion. Or, on constate sur cette figure que si la longueur L des sections est trop élevée (courbe a : L=30μm), le pic central se creuse pour devenir inexistant alors que les deux pics latéraux sont prépondérants. Dans ce cas la fenêtre spectrale est donc séparée en deux parties. En revanche, lorsque la longueur L des sections est trop courte (courbe c : L=15μm), le pic central devient prépondérant alors que les pics latéraux présentent un taux de réflexion moindre. Dans ce cas, la fenêtre spectrale présente une cassure de part et d'autre du pic central.

Par conséquent, pour que le profil de la fenêtre spectrale soit le plus plat et donc le plus large possible, la longueur des sections du réflecteur, lorsque celui-ci ne comporte que deux sections, est comprise entre 15 et 20μm. De préférence, elle est égale à 17μm.

De manière plus générale, la longueur L de chaque section du réflecteur dépend de l'indice de réfraction effectif et de la période de réseau des sections. La valeur de cette longueur L est plus particulièrement donnée par la relation générale approchée suivante :

$$L = \lambda^2 / [\, (n_{i+1} + n_i) \times 0,85(\, \lambda_{Bi+1} - \lambda_{Bi}\,)] \qquad (1)$$

où $\lambda$ est la valeur moyenne des longueurs d'onde de Bragg réfléchies par le réflecteur,

$n_{i+1}$ et $n_i$ sont les indices de réfraction effectifs respectivement des sections adjacentes $S_{i+1}$ et $S_i$, et

$\lambda_{Bi+1}$ et $\lambda_{Bi}$ sont les valeurs moyennes des longueurs d'onde de Bragg réfléchies respectivement par les sections adjacentes $S_{i+1}$ et $S_i$.

Les valeurs $\lambda_{Bi+1}$ et $\lambda_{Bi}$ dépendent par ailleurs de la période du réseau de Bragg de chaque section. Ces valeurs sont données par les relations suivantes :

$$\lambda_{Bi+1} = 2\, n_{i+1}\, \Lambda_{i+1} \qquad (2)$$

et

$$\lambda_{Bi} = 2\, n_i\, \Lambda_i \qquad (3)$$

où $\Lambda_{i+1}$ et $\Lambda_i$ sont les périodes de réseau respectivement des sections adjacentes $S_{i+1}$ et $S_i$.

D'après ces dernières relations (2) et (3), la relation (1) devient donc la suivante :

$$L = \lambda^2 / [\ (n_{i+1} + n_i) \times 1{,}7(n_{i+1}\ \Lambda_{i+1} - n_i\ \Lambda_i)] \tag{4}$$

Pour réaliser un réflecteur comportant des sections de réseau en cascade de même longueur L dont la valeur est choisie de telle sorte que la fenêtre spectrale soit large et au minimum égale à 30 nm, il faut donc faire varier la période effective entre les sections adjacentes. La période effective est définie comme étant le produit de la période réellement inscrite par l'indice de réfraction effectif des milieux que rencontre une onde lumineuse dans une section de réseau. Ainsi, pour faire varier la période effective, deux méthodes sont possibles: on peut faire varier soit l'indice de réfraction effectif $n_i$, $n_{i+1}$ en réalisant des sections de largeurs différentes $W_i$, $W_{i+1}$; soit la période $\Lambda_i$, $\Lambda_{i+1}$ du réseau de Bragg de chaque section.

La figure 4A schématise une vue de dessus d'un premier mode de réalisation d'un réflecteur optique selon l'invention. Dans l'exemple représenté le réflecteur comporte deux sections $S_1$, $S_2$ de réseau holographique de Bragg en cascade. Bien sûr, l'invention ne se limite pas à cet exemple et le réflecteur peut comporter plus de deux sections.

Dans cet exemple, les deux sections $S_1$ et $S_2$ présentent des périodes $\Lambda_1$ et $\Lambda_2$ de réseau identiques et des longueur $L_1$ et $L_2$ identiques. En revanche, elles possèdent des largeurs $W_1$ et $W_2$ différentes. Du fait de cette différence de largeur W entre les deux sections $S_1$ et $S_2$, la proportion d'air varie de part et d'autre de chaque section. Cette variation de la proportion d'air entre les deux sections entraîne une variation de l'indice de réfraction effectif $n_1$, $n_2$ entre les deux sections $S_1$ et $S_2$, c'est à dire que l'indice de guidage moyen des milieux que rencontre une onde lumineuse varie d'une section à l'autre.

La courbe de la figure 4B indique la variation de l'indice de réfraction effectif $n_{eff}$ de chaque section en fonction de la largeur W. Cette courbe indique par ailleurs que la variation maximale d'indice effectif en fonction de la largeur est égale à 3,235-3,170 = 0,065. Elle permet donc de connaître la valeur de la largeur de chaque section pour une variation d'indice effectif déterminée et correspondant à une longueur de section choisie.

Ainsi, lorsque l'on désire réaliser un réflecteur optique présentant une fenêtre spectrale de 30 nm centrée autour de la longueur d'onde $\lambda$ égale à 1,55μm, c'est à dire de période $\Lambda$ égale à 240 nm, le saut d'indice effectif $\Delta$neff entre les deux sections, qui dépend, de manière connue, de la largeur de la fenêtre spectrale du réflecteur, est déterminé et doit être égal à 0,05. Dans ce cas, si on choisit un indice effectif $n_1$ égal à 3,18, l'indice $n_2$ de l'autre section doit être égal à 3,18 + 0,05 = 3,23. La valeur de la longueur L de chaque section, donnée par la relation générale approchée (4), est ensuite calculée à partir des valeurs de $n_1$, $n_2$, $\lambda$ et $\Lambda$. Dans ce cas la longueur L est de l'ordre de 17 μm. Par ailleurs, d'après la courbe de la figure 4B, la largeur $W_1$ de la section $S_1$ ayant un indice effectif $n_1$ égal à 3,18, doit être égale à 1,2μm; et la largeur $W_2$ de la section $S_2$ ayant un indice effectif de 3,23 doit être égale à 2,5μm.

Ce réflecteur à indice effectif variable entre les sections de réseau adjacentes est réalisé selon un procédé simple de gravure en une seule étape au moyen d'un masque dont la forme correspond à celle des sections du réflecteur à réaliser. Pour cela, le procédé consiste dans un premier temps à réaliser une structure empilée classique comprenant un réseau holographique de Bragg possédant une période $\Lambda$ donnée et un coefficient de couplage $\kappa$ donné. Dans le cas où l'on souhaite réaliser un réflecteur destiné à réfléchir une onde vers une cavité laser, la période $\Lambda$ est par exemple réglée sur 240nm pour que la valeur moyenne de l'onde réfléchie par le réflecteur soit égale à 1,55μm. De plus, le réseau de Bragg est réalisé de manière classique, par gravure peu profonde suivie d'un rebouchage, et il présente un coefficient de couplage K satisfaisant et inférieur à 500 cm$^{-1}$. Dans un deuxième temps, la structure empilée ainsi réalisée est gravée latéralement, de manière à former des sections de réseau holographique en cascade présentant chacune une largeur W différente.

Le réflecteur est réalisé sur un substrat en matériau III-V, en InP par exemple. Le réseau holographique de Bragg dans lequel sont réalisées les sections est composé d'un matériau III-V, en InP par exemple, et d'un matériau ternaire, en GaInAs par exemple, ou quaternaire, en GaInAsP par exemple. Dans l'exemple décrit, les sections adjacentes comportent des couches guidantes de même composition.

Dans une variante de réalisation, on pourrait envisager de réaliser des sections adjacentes comportant des couches guidantes de composition différente. Cependant une telle variante complique le procédé de fabrication.

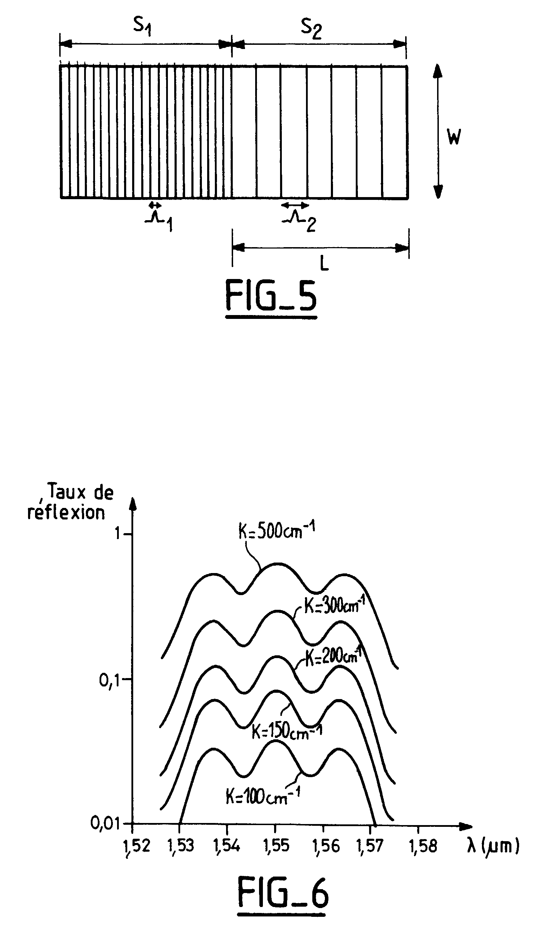

La figure 5 schématise une vue de dessus d'un second mode de réalisation d'un réflecteur optique selon l'invention. Dans ce mode de réalisation, les sections $S_1$ et $S_2$ de réseau holographique de Bragg en cascade présentent la même longueur L, la même largeur W et donc le même indice de réfraction effectif. En revanche, la période $\Lambda_1$, $\Lambda_2$ du réseau de chaque section $S_1$, $S_2$ est différente.

Le procédé de fabrication de ce réflecteur consiste dans un premier temps à réaliser une structure empilée comprenant une couche supérieure en matériau ternaire ou en matériau quaternaire destinée à être gravée pour former un réseau holographique. La couche supérieure est ensuite gravée sur une première section $S_1$ de longueur L, selon une configuration crénelée avec une période donnée $\Lambda_1$. Cette même couche supérieure est ensuite gravée sur une autre section $S_2$ adjacente à la précédente, de même longueur L, selon une autre configuration crénelée avec une autre période $\Lambda_2$. La gravure des créneaux est ainsi répétée sur chaque section Si du réflecteur. Enfin, après avoir effectué la gravure des créneaux de chaque section, on procède à la gravure de toutes les sections adjacentes de manière à ce qu'elles présentent une même largeur W et au dépôt d'une couche de gaine, en matériau III-V par exemple, afin de reboucher les créneaux et de créer plusieurs sections en cascade de réseau holographique présentant chacun une période différente. L'ordre de ces deux dernières étapes importe peu. La gravure de toutes les sections peut être réalisée indifféremment avant ou après l'étape de rebouchage des créneaux.

Ce procédé nécessitant plusieurs étapes, on ne l'utilise que pour réaliser un réflecteur comportant un nombre de sections limité à deux ou trois. Dans le cas où le réflecteur comporte plus de trois sections en cascade, il est de préférence fabriqué selon le premier mode de réalisation, en faisant varier l'indice de réfraction effectif d'une section à la suivante.

Quel que soit le mode de réalisation, le réflecteur selon l'invention possède un miroir qui est distribué entre les différentes sections $S_i$, $S_{i+1}$.

Les courbes de la figure 6 illustrent le profil de la fenêtre spectrale d'un réflecteur selon l'invention, comportant deux sections de longueur égale à 17$\mu$m chacune et présentant un saut d'indice de 0,05, en fonction de son coefficient de couplage $\kappa$. Cette figure démontre que la largeur de la fenêtre spectrale varie très peu en fonction du coefficient de couplage $\kappa$ puisqu'elle est égale à 40nm lorsque le coefficient de couplage $\kappa$ est égal à 100 cm$^{-1}$; et elle est égale à 50nm lorsque le coefficient de couplage $\kappa$ est égal à 500 cm$^{-1}$. En revanche, les courbes confirment que le taux de réflexion varie avec le coefficient de couplage, puisqu'il est de l'ordre de 2 à 3% lorsque $\kappa$ est égal à 100 cm$^{-1}$ et il augmente jusqu'à environ 40% lorsque $\kappa$ est égal à 500 cm$^{-1}$. Par conséquent, le coefficient de couplage $\kappa$ du réflecteur selon l'invention est choisi selon l'application à laquelle il est destiné et notamment selon la nature de la cavité laser vers laquelle il doit réfléchir une onde lumineuse.

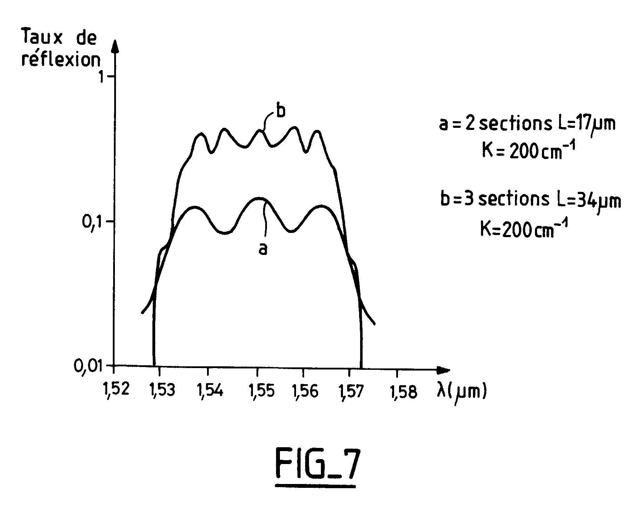

La figure 7 représente des courbes illustrant le profil de la fenêtre spectrale d'un réflecteur selon l'invention en fonction du nombre de sections adjacentes. La courbe référencée a représente le profil de la fenêtre spectrale d'un réflecteur selon l'invention comportant deux sections de longueur égale à 17 $\mu$m chacune et ayant un coefficient de couplage $\kappa$ égal à 200 cm$^{-1}$. La courbe référencée b représente le profil de la fenêtre spectrale d'un réflecteur selon l'invention comportant trois sections de longueur égale à 34$\mu$m chacune et ayant un coefficient de couplage $\kappa$ égal à 200 cm$^{-1}$. Ces deux courbes indiquent que plus le réflecteur comporte de sections de réseau de Bragg, plus le profil de la fenêtre spectrale s'aplatit.

Ces deux courbes indiquent en outre que le taux de réflexion augmente avec le nombre de sections de réseau de Bragg que comporte le réflecteur. Ainsi, pour un réflecteur possédant un coefficient de couplage $\kappa$ égal à 200 cm$^{-1}$, le taux de réflexion est de l'ordre de 10% lorsqu'il comporte deux sections, alors que ce taux est de l'ordre de 50% lorsqu'il comporte trois sections.

De plus, dans cet exemple la longueur L de chaque section est calculée pour une variation totale d'indice de réfraction effectif de 0,05. Ceci signifie que dans le cas d'un réflecteur à deux sections, l'indice de réfraction effectif de chaque section étant respectivement égal à 3,205 et 3,255, la longueur L de chaque section, donnée par la relation (4) est de l'ordre de 17$\mu$m. En revanche, dans le cas d'un réflecteur à trois sections, l'indice de réfraction de chaque section est respectivement égal à 3,205 ; 3,23 ; 3,255 pour avoir une variation totale de 0,05. Dans ce cas, la longueur L de chaque section, donnée par la relation (4), est de l'ordre de 34$\mu$m.

## Revendications

1.  Réflecteur optique en semi-conducteur comprenant plusieurs sections ($S_i$, $S_{i+1}$) de réflecteur de Bragg en cascade, caractérisé en ce que lesdites sections sont de même longueur L et ont un même coefficient de couplage (K), et en ce que la longueur L de chacune desdites sections est donnée par la relation suivante :

$$L = \lambda^2 / [\, (n_{i+1} + n_i) \times 1,7(n_{i+1}\,\Lambda_{i+1} - n_1\,\Lambda_i)]$$

où $\lambda$ est la valeur moyenne des longueurs d'ondes de Bragg réfléchies par le réflecteur,
$n_{i+1}$ et $n_i$ sont les indices de réfraction effectifs respectivement desdites sections adjacentes ($S_{i+1}$, $S_i$), et
$\Lambda_{i+1}$ et $\Lambda_i$ sont les périodes respectivement desdites sections adjacentes ($S_{i+1}$, $S_i$).

2.  Réflecteur selon la revendication 1, caractérisé en ce que l'indice de réfraction effectif varie d'une section à l'autre ($n_{i+1} \neq n_i$) tandis que la période reste identique ($\Lambda_{i+1} = \Lambda_i$).

3. Réflecteur selon l'une des revendications 1 à 2, caractérisé en ce que la largeur ($W_{i+1}$, $W_i$) de chaque section ($S_{i+1}$, $S_i$) est différente.

4. Réflecteur selon la revendication 1, caractérisé en ce que la période varie d'une section à la suivante ($\Lambda_{i+1} \neq \Lambda_i$) tandis que l'indice de réfraction effectif reste identique ($n_{i+1} = n_i$).

5. Réflecteur selon l'une des revendications 1 à 4, caractérisé en ce que, lorsque le réflecteur comporte deux sections ($S_1$, $S_2$), la longueur (L) de chacune desdites sections est comprise entre 15 et 20µm, de préférence elle est égale à 17µm.

6. Réflecteur selon l'une des revendications 1 à 5, caractérisé en ce que les sections adjacentes ($S_i$, $S_{i+1}$) comportent des couches guidantes de même composition.

7. Réflecteur selon l'une des revendications 1 à 6, caractérisé en ce que le coefficient de couplage ($\kappa$) desdites sections adjacentes ($S_i$, $S_{i+1}$) est inférieur à 500 cm$^{-1}$.

8. Procédé de fabrication d'un réflecteur selon l'une des revendications 1 à 3 et 5 à 7, consistant dans un premier temps à réaliser une structure empilée comprenant un réseau holographique de Bragg possédant une période ($\Lambda$) donnée et un coefficient de couplage donné, caractérisé en ce qu'il consiste dans un deuxième temps à graver latéralement ladite structure empilée, de manière à former des sections ($S_i$, $S_{i+1}$) de réseau holographique en cascade présentant chacune une largeur différente ($W_i$, $W_{i+1}$).

9. Procédé de fabrication d'un réflecteur optique selon l'une des revendications 1 ou 4 à 7, consistant dans un premier temps à réaliser une structure empilée comprenant une couche supérieure en matériau ternaire ou en matériau quaternaire destinée à être gravée pour former un réseau holographique, caractérisé en ce qu'il consiste ensuite à :

- graver la couche supérieure sur une section ($S_i$), de longueur L, selon une configuration crénelée avec une période donnée ($\Lambda_i$),
- graver successivement la couche supérieure sur une section adjacente ($S_{i+1}$) à la précédente, de même longueur L, selon une autre configuration crénelée avec une autre période ($\Lambda_{i+1}$),
- puis, après avoir effectuer successivement la gravure des créneaux de chaque section, procéder indifféremment à la gravure de toutes les sections adjacentes, de manière à ce qu'elles présentent une même largeur (W), et au dépôt d'une couche de gaine, en matériau III-V, afin de reboucher les créneaux et de créer plusieurs sections ($S_i$, $S_{i+1}$) en cascade de réseau holographique présentant chacun une période différente ($\Lambda_i$, $\Lambda_{i+1}$).

FIG_1A

FIG_1B

FIG_2

a _ K=100 cm⁻¹

b _ K=200 cm⁻¹

c _ K=300 cm⁻¹

d _ K=500 cm⁻¹

e _ K=1000 cm⁻¹

FIG_3

Taux de réflexion

a _ L=30 μm
b _ L=20 μm
c _ L=15 μm

FIG_4A

FIG_4B

$$\underline{FIG\_5}$$

$$\underline{FIG\_6}$$

FIG_7

**Office européen
des brevets**

**RAPPORT DE RECHERCHE EUROPEENNE**

Numéro de la demande

EP 99 40 0420

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | DE 195 00 136 A (DEUTSCHE TELEKOM AG) 11 juillet 1996 <br> * abrégé; figure 1 * <br> * colonne 2, ligne 7 - ligne 22 * <br> * colonne 2, ligne 35 - ligne 55 * | 1,4,9 | G02B6/124 <br> H01S3/085 |
| A | FR 2 742 235 A (ALCATEL NV) 13 juin 1997 <br> * abrégé; figures 3,5 * <br> * page 2, ligne 5 - ligne 21 * <br> * page 3, ligne 5 - ligne 26 * | 1,9 | |
| A | EP 0 632 298 A (ANT NACHRICHTENTECH) 4 janvier 1995 <br> * abrégé; figures 1,2 * <br> * page 3, ligne 16 - page 4, ligne 2 * | 1,8 | |
| A | US 5 601 731 A (HILLMER HARTMUT) 11 février 1997 <br> * abrégé; figures 1,2 * <br> * colonne 3, ligne 63 - colonne 4, ligne 6 * <br> * colonne 5, ligne 3 - ligne 20 * | 1,8,9 | |
| | | | **DOMAINES TECHNIQUES RECHERCHES (Int.Cl.6)** <br> G02B <br> H01S |
| A | WO 93 21671 A (NORTHERN TELECOM LTD ;PHILLIPS NICHOLAS JOHN (GB); YEO TERENCE EDW) 28 octobre 1993 <br> * page 1; figures 1-8 * <br> * page 2 * | 1,9 | |
| A | EP 0 647 867 A (ANT NACHRICHTENTECH) 12 avril 1995 <br> * abrégé; figure 1 * <br> * colonne 2, ligne 6 - ligne 53 * | 1 | |

Le présent rapport a été établi pour toutes les revendications

| Lieu de la recherche | Date d'achèvement de la recherche | Examinateur |
|---|---|---|
| LA HAYE | 7 juin 1999 | Jakober, F |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.............................................................
& : membre de la même famille, document correspondant

EPO FORM 1503 03.82 (P04C02)

12

**ANNEXE AU RAPPORT DE RECHERCHE EUROPEENNE
RELATIF A LA DEMANDE DE BREVET EUROPEEN NO.**  EP 99 40 0420

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

07-06-1999

| Document brevet cité au rapport de recherche | | Date de publication | Membre(s) de la famille de brevet(s) | | Date de publication |
|---|---|---|---|---|---|
| DE 19500136 | A | 11-07-1996 | AUCUN | | |
| FR 2742235 | A | 13-06-1997 | AUCUN | | |
| EP 0632298 | A | 04-01-1995 | DE | 4322163 A | 12-01-1995 |
| US 5601731 | A | 11-02-1997 | DE | 4407832 A | 14-09-1995 |
| | | | EP | 0671640 A | 13-09-1995 |
| WO 9321671 | A | 28-10-1993 | EP | 0635168 A | 25-01-1995 |
| | | | GB | 2276034 A,B | 14-09-1994 |
| | | | JP | 7508593 T | 21-09-1995 |
| EP 0647867 | A | 12-04-1995 | DE | 4334525 A | 13-04-1995 |